# EUROPÄISCHE PATENTSCHRIFT

(11) **EP 1 324 054 B1**
(45) Veröffentlichungstag und Bekanntmachung des Hinweises auf die Patenterteilung: **31.03.2010**
(21) Anmeldenummer: 02025849.7
(22) Anmeldetag: 19.11.2002
(51) Int. Cl.: G01R 33/09, G01R 15/20

(54) **Vorrichtung zur Messung der Stärke eines magnetischen Feldes, Magnetfeldsensor und Stromstärkemessgerät**
Device for measuring the intensity of a magnetic field, magnetic field sensor and current intensity measuring instrument
Dispositif pour mesurer l'intensité d'un champ magnétique, détecteur de champs magnétiques et appareil de mesure de l'intensité du courant

(30) Priorität: 30.11.2001 DE 10159005
(43) Veröffentlichungstag der Anmeldung: 02.07.2003
(73) Patentinhaber: ROBERT BOSCH GMBH, 70442 Stuttgart (DE)
(72) Erfinder: Heinisch, Holger, 72760 Reutlingen (DE); Feiler, Wolfgang, 72766 Reutlingen (DE); Qu, Ning, 72770 Reutlingen (DE)

(56) Entgegenhaltungen:
- DE-A- 19 650 078
- US-A1- 2001 033 471
- PATENT ABSTRACTS OF JAPAN vol. 2000, no. 19, 5. Juni 2001 (2001-06-05) & JP 2001 035345 A (YAZAKI CORP), 9. Februar 2001 (2001-02-09)

## Beschreibung

### Stand der Technik

Die Erfindung geht aus von einer Vorrichtung, einem Magnetfeldsensor und einem Stromstärkemessgerät gemäß dem Oberbegriff der nebengeordneten Ansprüche. Für die Strommessung ist es allgemein bekannt, Leistungsbauelemente vorzusehen, wobei der gesamte Ausgangsstrom des Leistungsbauelements durch einen Shunt-Widerstand fließt. An einem solchen Shunt-Widerstand entsteht ein Spannungsabfall, der dem fließenden Strom proportional ist. Der Shunt-Widerstand kann auch in das Bauelement integriert werden.

Ein weiteres, allgemein bekanntes Prinzip zur Messung des Stromes bei Leistungshalbleitern besteht darin, dass eine von mehreren parallel geschalteten Zellen von solchen Leistungshalbleiterbauelementen, die insbesondere als MOS-Bauelemente vorgesehen sind, als Sense-Zelle ausgeführt ist. Am Sense-Widerstand entsteht ein Spannungsabfall, der dem Ausgangsstrom annähernd proportional ist.

Ein weiteres, allgemein bekanntes Messprinzip zur Strommessung besteht darin, die Stärke eines durch einen elektrischen Leiter fließenden Stromes durch Magnetfeldsensoren zu messen, welche sich in unmittelbarer Nähe des Leiters befinden. Bekannt sind Lösungen, die Magnetfeldsensoren mit einer Auswerteschaltung und einem integrierten Schaltkreis kombinieren. Ein solches Stromstärkemessgerät ist insbesondere in der deutschen Offenlegungsschrift DE 44 10 180 offenbart. Wenn Magnetfeldsensoren symmetrisch an zwei Seiten eines stromführenden Leiters angeordnet werden, dann kann durch Subtraktion der Ausgangssignale das durch den stromführenden Leiter erzeugte Magnetfeld gemessen werden, während sich die durch externe Störfelder erzeugten Signale aufheben.

Nachteilig bei der Strommessung mittels eines Shunt-Widerstands ist, dass aufgrund der Umsetzung von im Shunt-Widerstand dissipierter elektrischer Leistung in Wärme, solche Shunt-Widerstände vorrangig bei relativ kleinen beziehungsweise bei mittleren Strömen verwendbar sind.

Nachteilig bei der Strommessung einer Sense-Zelle ist, dass durch den Spannungsabfall am Sense-Widerstand eine Stromgegenkopplung entsteht, so dass die Sense-Zelle bei einem anderen Arbeitspunkt betrieben wird als die anderen Zellen des Leistungshalbleiterbauelements. Der Strom durch die Sense-Zelle und damit der Spannungsabfall am Sense-Widerstand ist deshalb dem Ausgangsstrom nur annähernd proportional. Aufgrund der Stromgegen-kopplung ist die Sense-Zelle einer anderen Belastung ausgesetzt als die übrigen Zellen. Deshalb sind die anderen Zellen in verschiedenem Maße von alterungsbedingten Parameterveränder-ungen betroffen als die Sense-Zelle. Dies führt zu einer alterungsbedingten Veränderung des Proportionalitätsfaktors, der gegeben ist durch die Spannung an der Sense-Zelle, d.h. Spannungsabfall, dividiert durch den zu messenden Laststrom.

Aus der US 2001/00 33471 A1 ist eine Vorrichtung zur Strommessung bekannt, bei der der Strom mit Hilfe zweier Sensorelemente sowie einer zugeordneten Auswerteschaltung gemessen wird.

Aus der DE 196 50 078 A1 ist ein Sensor zur Bestimmung eines Magnetfeldes oder eines Stroms bekannt, bei der zwei Sensormittel an verschiedenen Orten angeordnet sind. Die Anordnung der beiden Sensormittel erfolgt so, dass am ersten Ort und am zweiten Ort das zu messende Feld betragsmäßig im Wesentlichen gleich aber im Wesentlichen antiparallel orientiert ist. Die Sensormittel sind beispielsweise magnetoresistive Sensoren. Die Änderung des Widerstandes der magnetoresistiven Sensoren wird mit Hilfe einer Auswerteschaltung ausgewertet und zu einem Messsignal verarbeitet.

### Vorteile der Erfindung

Die erfindungsgemäße Vorrichtung, der erfindungsgemäße Magnetfeldsensor und das erfindungsgemäße Stromstärkemessgerät mit den Merkmalen der nebengeordneten Patentansprüche haben demgegenüber den Vorteil, dass ein weit geringerer Leistungsverlust entsteht als durch die Messung des Spannungsabfalls an einem integrierten Shunt-Widerstand. Weiterhin haben alterungsbedingte Parameterveränderungen des Leistungshalbleiterbauelements keine Auswirkung auf den Proportionalitätsfaktor, weil durch eine Kombination einer Sense-Zelle mit den Magnetfeldsensoren alterungsbedingte Parameterveränderungen detektiert werden können, wobei die Alterung der Magnetfeldsensoren in der Regel vernachlässigbar ist. Gegenüber der Strommessung mittels einer Sense-Zelle ist eine bessere Linearität bei der erfindungsgemäßen Vorrichtung zu erwarten. Weiterhin ist vorteilhaft, dass das auf der erfindungsgemäßen Vorrichtung basierende Verfahren prinzipiell für alle Leistungshalbleiterbauelemente geeignet ist. Durch eine monolithische Integration, sowohl des ersten als auch des zweiten Sensormittels, ist es möglich, weitgehend die Wirkung von Störfeldern auszuschalten, weil die Sensormittel einerseits sehr nahe an den zu sensierenden Strompfad herangebracht werden und andererseits die Sensormittel auch sehr nahe beieinander angeordnet werden können, so dass das Störfeld über die räumliche Ausdehnung der Sensormittel als weitgehend konstant vorausgesetzt werden kann.

Die Unterbringung von Sensormitteln und Auswerteschaltungen in einem Gehäuse hat weiterhin den Vorteil, dass kein oder nur ein sehr geringer Montageaufwand zur Auswertung des erfindungsgemäßen Stromstärkemessgerätes beziehungsweise der erfindungsgemäßen Vorrichtung betrieben werden muss.

### Zeichnung

Ausführungsbeispiele der Erfindung sind in der Zeichnung dargestellt und in der nachfolgenden Beschreibung näher erläutert. Es zeigen
Figur 1 eine erste erfindungsgemäße Ausführungsform einer erfindungsgemäßen Vorrichtung,
Figur 2 eine zweite Ausführungsform der erfindungsgemäßen Vorrichtung,
Figur 3 eine Detaildarstellung der ersten Ausführungsform der erfindungsgemäßen Vorrichtung,
Figur 4 eine Detaildarstellung der zweiten Ausführungsform der erfindungsgemäßen Vorrichtung,
Figur 5 eine Schaltungsanordnung für die erste Ausführungsform der erfindungsgemäßen Vorrichtung und
Figur 6 eine Schaltungsanordnung für die zweite Ausführungsform der erfindungsgemäßen Vorrichtung.

### Beschreibung der Ausführungsbeispiele

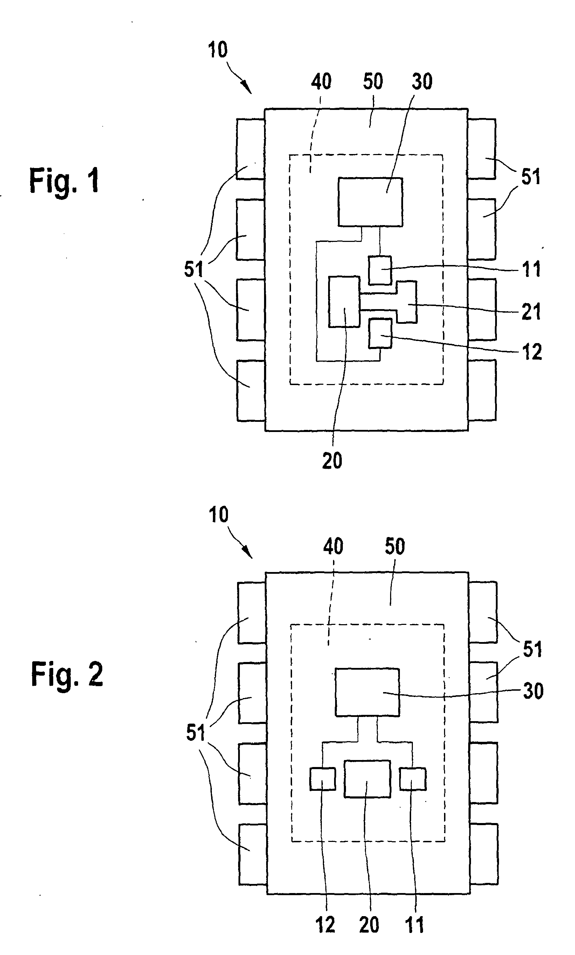

In Figur 1 ist eine erfindungsgemäße Vorrichtung 10 zur Messung der Stärke eines magnetischen Feldes dargestellt. Die erfindungsgemäße Vorrichtung 10 umfasst ein Gehäuse 50, welches ein Substrat 40 umfasst, wobei das Substrat 40 in der Regel als Halbleitersubstrat, bspw. Siliziumsubstrat, vorgesehen ist. Auf dem Substrat 40 umfasst die Vorrichtung 10 eine Auswerteschaltung 30, ein Leistungshalbleiterbauelement 20, eine Stromleiterbahn 21 sowie ein erstes Magnetfeldsensormittel 11 und ein zweites Magnetfeldsensormittel 12. Die Magnetfeldsensormittel 11, 12 werden im folgenden auch einfach als Sensormittel 11, 12 bezeichnet. Die Leiterbahn 21 ist erfindungsgemäß insbesondere als Metallleiterbahn 21 vorgesehen, es kann sich hierbei auch jedoch um eine Leiterbahn aus Kanälen und Driftgebieten von lateralen Power-MOS-Feldeffekttransistoren handeln. Das Leistungshalbleiterbauelement 20 kann als Leistungstransistor oder als IGBT (Insulated Gate Bipolar Transistor) ausgeführt sein.

Die Sensormittel 11, 12 sind im ersten Ausführungsbeispiel generell als Magnetfeldsensoren ausgebildet, insbesondere jedoch als magnetische Feldeffekttransistoren.

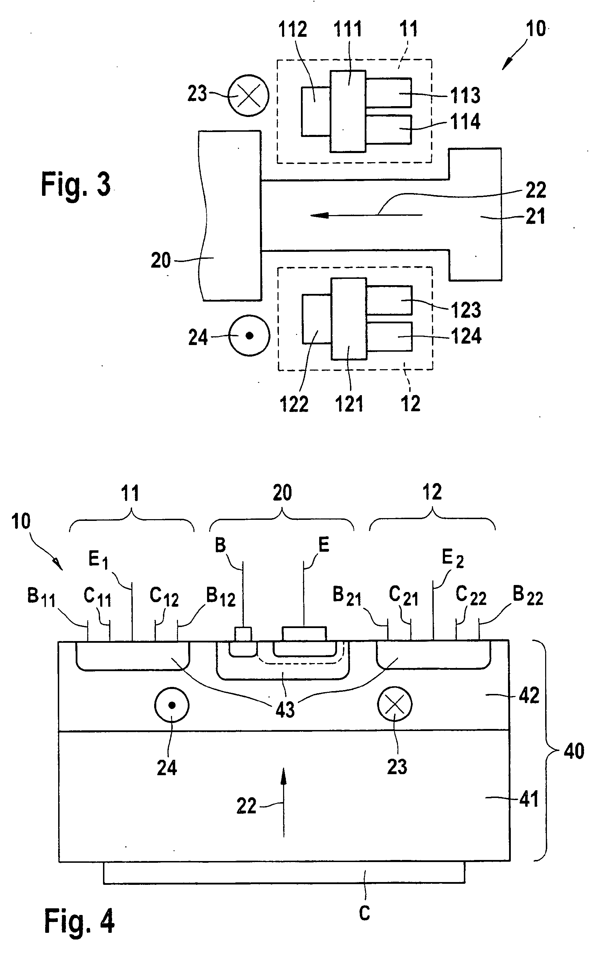

In Figur 3 ist das erste Ausführungsbeispiel der erfindungsgemäßen Vorrichtung 10 mit mehr Details dargestellt. Dargestellt ist wiederum das Leistungshalbleiterbauelement 20, oder zumindest ein Teil davon. Weiterhin ist die Leiterbahn 21 dargestellt, welche einen Stromfluss trägt, welcher mit einem durch den mit dem Bezugszeichen 22 versehenen Pfeil dargestellt ist. Der mit dem Bezugszeichen 22 versehene Stromfluss verursacht ein Magnetfeld, welches sich um den Stromfluss herum ausbildet. Da der Pfeil 22 in der Zeichenebene der Figur 3 von rechts nach links weist, erzeugt er ein Magnetfeld, dessen Magnetfeldlinien oberhalb des Pfeils 22 in die Zeichenebene hineinweisen und dessen Magnetfeldlinien unterhalb des Pfeils 22 aus der Zeichenebene herausweisen. Hierzu ist für die oberhalb des Pfeils 22 in die Zeichenebene hineinweisenden Magnetfeldlinien ein mit dem Bezugszeichen 23 versehener Kreis mit einem einbeschriebenen Kreuz in Figur 3 dargestellt, welcher die in die Zeichenebene hineinweisenden Magnetfeldlinien darstellen soll. Weiterhin ist ein mit dem Bezugszeichen 24 versehener Kreis in Figur 3 vorgesehen, welcher einen Punkt einbeschrieben hat, der die unterhalb des Pfeils 22 aus der Zeichenebene der Figur 3 herausweisenden Magnetfeldlinien darstellt.

Oberhalb und unterhalb der Leiterbahn 21 befinden sich die Sensormittel 11, 12, wobei sich das erste Sensormittel 11 oberhalb der Leiterbahn 21 befindet und wobei sich das zweite Sensormittel 12 unterhalb der Leiterbahn 21 befindet. Das erste Sensormittel 11 ist erfindungsgemäß insbesondere als sogenannter magnetischer Feldeffekttransistor oder auch als magFET vorgesehen. Das erste Sensormittel 11 umfasst als magFET einen Sourceanschluss 112, einen Gateanschluss 111, sowie zwei Drainanschlüsse, nämlich den ersten Drainanschluss 113 und den zweiten Drainanschluss 114. Durch den mit dem Bezugszeichen 22 versehenen Pfeil, der den Stromfluss durch die Leiterbahn 21 darstellt, wird ein Magnetfeld erzeugt, welches vertikal zur in Figur 3 nicht dargestellten Chipebene - die jedoch mit der Zeichnungsebene zusammenfällt - verläuft. Durch dieses magnetische Feld - vergleiche die mit den Bezugszeichen 23 und 24 bezeichneten Symbole - werden die in den Kanälen des in der ersten Ausführungsform der erfindungsgemäßen Vorrichtung als magFET ausgebildeten Sensormittels 11 so abgelenkt, dass der zweite Drainanschluss 114 einen größeren Strom trägt als der erste Drainanschluss 113.

Entsprechend dem ersten Sensormittel 11 weist das zweite Sensormittel 12 bei der ersten Ausführungsform der erfindungsgemäßen Vorrichtung in Figur 3 ebenfalls einen magFET auf, welcher ebenfalls einen Sourceanschluss besitzt, welcher mit dem Bezugszeichen 122 versehen ist, der ebenfalls einen Gateanschluss aufweist, der mit dem Bezugszeichen 121 versehen ist, und der einen dritten Drainanschluss 123 und einen vierten Drainanschluss 124 aufweist. Bei einem Stromfluss 22 durch die Leiterbahn 21 führt wiederum das durch die Feldlinien 23 und 24 angedeutete Magnetfeld für den dritten Drainanschluss 123 zu einem größerem Strom als beim vierten Drainan- schluss 124.

Externe Störfelder bewirken dagegen gleichartige Änderungen der Stromflüsse durch die Drainabschnitte 113, 114 bzw. 123, 124, weil sie über die räumliche Ausdehnung der Sensormittel 11, 12 als konstant vorausgesetzt werden können.

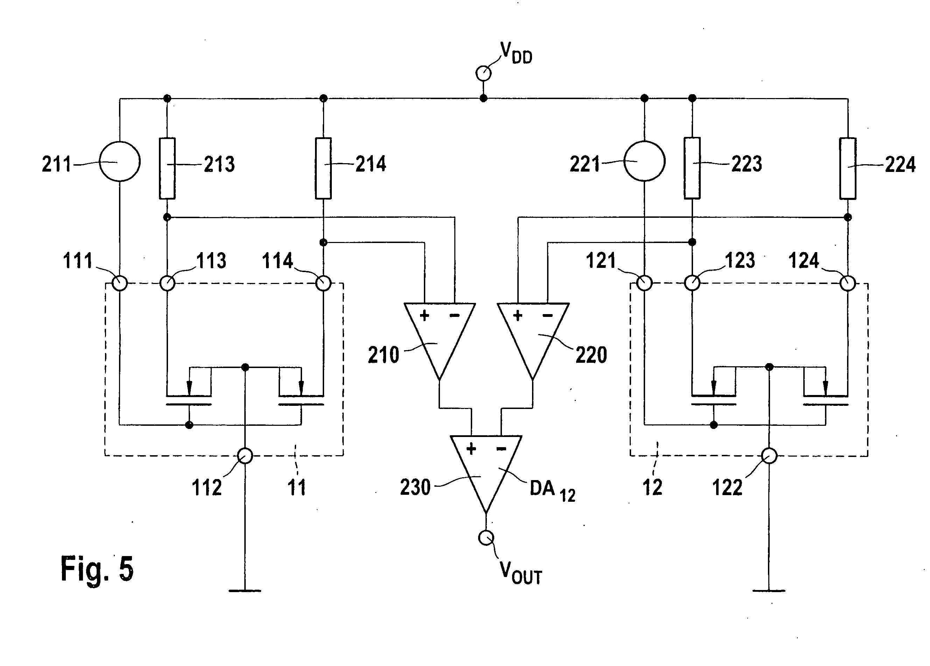

In Figur 5 ist eine Schaltungsanordnung zur Auswertung der Strommessung durch die Sensormittel 11, 12 entsprechend dem ersten Ausführungsbeispiel der erfindungsgemäßen Vorrichtung 10 dargestellt. In Figur 5 ist wiederum das erste und zweite Sensormittel 11, 12 dargestellt. Das erste Sensormittel 11 umfasst seinen Sourceanschluss 112, seinen Gateanschluss 111 sowie den ersten und zweiten Drainanschluss 113, 114. Das zweite Sensormittel 12 ist, ebenfalls als magFET ausgeführt, mit seinem Sourceanschluss 122, seinem Gateanschluss 121 sowie seinem dritten Drainanschluss 123 und seinem vierten Drainanschluss 124 dargestellt. Der erste Drainanschluss 113 ist über einen ersten Widerstand 213 mit der Versorgungsspannung V_{DD} verbunden. Ebenso ist der zweite Drainanschluss 114 über einen zweiten Widerstand 214, der dritte Drainanschluss 123 über einen dritten Widerstand 223 und der vierte Drainanschluss 124 über einen vierten Widerstand 224 mit der Versorgungsspannung verbunden. Der Gateanschluss 111 des ersten Sensormittels 11 ist über eine Spannungsregelung 211 mit der Versorgungsspannung verbunden und der Gateanschluss 121 des zweiten Sensormittels 12 ist ebenfalls mit einer Spannungsregelung 221 mit der Versorgungsspannung verbunden. Der über den ersten Drainanschluss 113 fließende Strom kann mittels eines Abgriffs zwischen dem ersten Widerstand 213 und dem ersten Drainanschluss 113 und der Messung des dortigen Spannungsabfalls ermittelt werden. Entsprechend können die Ströme am zweiten, dritten und vierten Drainanschluss 114, 123, 124 ermittelt werden. Hierzu wird der entsprechende Abgriff am ersten Drainanschluss 113, beispielsweise dem negierenden Eingang und der entsprechende Abgriff am zweiten Drainanschluss 114 dem nicht invertierenden Eingang eines ersten Differenzverstärkers 210 zugeführt und es wird der entsprechende Abgriff am vierten Drainanschluss 124 dem nicht invertierenden Eingang und der entsprechende Abgriff am dritten Drainanschluss 123 dem invertierenden Eingang eines zweiten Differenzverstärkers 220 zugeführt. Der Ausgang des ersten Differenzverstärkers 210 wird dem nicht invertierenden Eingang eines dritten Differenzverstärkers 230 und der Ausgang des zweiten Differenzverstärkers 220 wird dem invertierenden Eingang des dritten Differenzverstärkers 230 zugeführt. Das Ausgangssignal des dritten Differenzverstärkers 230 ist dem zu erfassenden Magnetfeld proportional. Externe Störfelder bewirken gleichartige Änderungen der Stromflüsse durch die Drainabschnitte 113, 114, 123, 124. Die daraus resultierenden Spannungsabfälle an den Widerständen 213, 214, 223, 224 werden durch die Differenzverstärker 210, 220, 230 so zusammengefasst, dass sich keine Wirkung auf das Ausgangssignal ergibt. Eventuell mögliche Temperaturabhängigkeiten können durch integrierte Regelschaltungen reduziert werden, welche auf die Gatespannungen, d.h. die Spannungsregelungseinrichtungen 211, 221 der magFETs 11, 12 wirken.

Ein zweites Ausführungsbeispiel der erfindungsgemäßen Vorrichtung 10 ist in Figur 2 dargestellt. In Figur 2 ist wiederum das Gehäuse 50 und das Halbleitersubstrat 40 dargestellt, welches eine Auswerteschaltung 30, ein Leistungshalbleiterbauelement 20 sowie ein erstes Sensormittel 11 und ein zweites Sensormittel 12 umfasst. Im Gegensatz zum ersten Ausführungsbeispiel der erfindungsgemäßen Vorrichtung ist es jedoch beim zweiten Ausführungsbeispiel vorgesehen, dass der Stromfluss vertikal durch das Substrat 40 fließt und somit ein Magnetfeld erzeugt, welches in der Substratebene befindlich ist, im Gegensatz zum ersten Ausführungsbeispiel, bei dem der Stromfluss in der Substratebene verlief und das Magnetfeld vertikal zu dieser vorgesehen war.

In Figur 4 ist eine Detailansicht des erfindungsgemäßen Leistungshalbleiterbauelements 20 inklusive der beiden Sensormittel 11, 12 gemäß dem zweiten Ausführungsbeispiel der Erfindung dargestellt. Das Substrat 40 weist einen ersten Bereich 41 auf, welcher mittels einer ersten Ladungsträgerart dotiert ist. Die erste Ladungsträgerart ist erfindungsgemäß insbesondere als Donatorendotierung vorgesehen, es ist jedoch auch eine umgekehrte Definition von erster und später zu beschreibender zweiter Ladungsträgerart erfindungsgemäß möglich. Das Halbleitersubstrat 40 weist weiterhin einen zweiten Bereich 42 auf, welcher ebenfalls mittels der ersten Ladungsträgerart dotiert ist, jedoch schwächer als im ersten Bereich 41. Weiterhin weist das Substrat 40 für das Leistungshalbleiterbauelement 20 und die Sensormittel 11 und 12 jeweils einen dritten Bereich 43 des Substrates 40 auf, welcher mittels einer zweiten Ladungsträgerart, erfindungsgemäß also insbesondere eine Akzeptordotierung, dotiert ist. Die dem Leistungshalbleiterbauelement 20 und den Sensormitteln 11, 12 jeweils zugeordneten dritten Bereiche 43 des Halbleitersubstrates 40 überlappen sich innerhalb des zweiten Bereichs 42 des Substrates 40 nicht. Das Leistungshalbleiterbauelement 20 ist erfindungsgemäß in der zweiten Ausführungsform insbesondere als vertikaler, bipolarer Leistungstransistor 20 mit einem angedeuteten und mit dem Bezugszeichen B vorsehenen Basisanschluss und mit einem mit dem Bezugszeichen E versehenen Emitteranschluss vorgesehen. Hierzu weist der dritte Bereich 43, welcher dem Leistungshalbleiterbauelement 20 zugeordnet ist, weitere Dotierungsbereiche nach der Art von vertikalen, bipolaren Leistungstransistoren auf. Rechts und links von dem in Figur 4 in der Mitte des Halbleitersubstrates 40 dargestellten Leistungshalbleiterbauelements 20 befindet sich jeweils ein lateraler Magnetotransistor als Sensormittel 11, 12. Das als lateraler Magnetotransistor (LMT) vorgesehene erste Sensormittel 11 umfasst gemäß der zweiten Ausführungsform der Erfindung etwa in der Mitte des dem ersten Sensorelement 11 zugeordneten dritten Bereiches 43 des Substrates 40 einen Emitteranschluss, der mit dem Bezugszeichen E₁ bezeichnet ist und seitlich neben dem Emitteranschluss E₁ jeweils ein Kollektoranschluss und einen Basisanschluss im Bereich des dritten Bereiches 43, wobei die vom Leistungshalbleiterbauelement 20 abgewandten Anschlüsse des ersten Sensormittels 11 mit dem Bezugszeichen B₁₁ für den ersten Basisanschluss und C₁₁ für den zweiten Basisanschluss versehen sind. Die dem Leistungshalbleiterbauelement 20 zugewandten Anschlüsse des ersten Sensormittels 11 weisen die Bezugszeichen C₁₂ für den Kollektoranschluss und B₁₂ für den Basisanschluss des als erstes Sensormittel 11 vorgesehenen LMT auf. Entsprechend ist als zweites Sensormittel 12 ebenfalls ein LMT mit einem in seinem dritten Substratbereich 43 mittig vorgesehenen und mit dem Bezugszeichen E₂ versehenen Emitter dargestellt. Auch das als LMT vorgesehene zweite Sensormittel 12 umfasst beidseitig zum mittig vorgesehenen Emitteranschluss E₁₂ jeweils einen Basisanschluss und einen Kollektoranschluss nach der Art von bekannten LMT-Bauelementen. Hierbei ist in Figur 4 der dem Leistungshalbleiterbauelement 20 zugewandte Basisanschluss mit dem Bezugszeichen B₂₁, der dem Leistungshalbleiterbauelement 20 zugewandte Kollektoranschluss mit dem Bezugszeichen C₂₁ und die jeweils abgewandten Anschlüsse mit den Bezugszeichen C₂₂ und B₂₂ bezeichnet. In Figur 4 ist weiterhin ein mit dem Bezugszeichen 22 versehener Stromfluss dargestellt, welcher ein in der Substratebene verlaufendes Magnetfeld erzeugt, welches mit den Bezugszeichen 23 und 24 angedeutet ist, wobei das Bezugszeichen 23 ein in die Zeichenebene der Figur 4 hinweisendes Magnetfeld und das Bezugszeichen 24 ein aus der Zeichenebene der Figur 4 herausweisendes Magnetfeld darstellt. Der Stromfluss gemäß dem Bezugszeichen 22 entspricht einem Strom negativer Ladungsträger in dem Substrat 40 von den mittels der zweiten Ladungsträgerart dotierten dritten Bereich 43 des Leistungshalbleiterbauelements 20 nach unten zum ersten Bereich 41 des Substrates 40. Auf der den dritten Bereichen 43 des Substrates 40 gegenüberliegenden Seite des Substrates 40 befindet sich ein Kollektoranschluss des Leistungshalbleiterbauelements 20, welcher mit dem Bezugszeichen C versehen ist. Die LMT-Elemente 11, 12 sind in Figur 4 auf beiden Seiten des zu messenden vertikalen Strompfades - Bezugszeichen 22 - angeordnet, wobei der vertikale Strompfad durch das Leistungshalbleiterbauelement 20 in Form eines vertikalen, bipolaren Leistungstransistors verwirklich ist. Durch den Stromfluss 22 entsteht ein magnetisches Feld, parallel zur Chipebene - Bezugszeichen 23 und 24. Durch dieses magnetische Feld 23, 24 werden die in den Sensormitteln 11, 12 fließenden Ströme so abgelenkt, dass die durch die dem Leistungshalbleiterbauelement 20 zugewandten Kollektoren C₁₂ und C₂₁ der Sensormittel 11, 12 fließenden Ströme größer sind als diejenigen Ströme, die durch die dem Leistungshalbleiterbauelement 20 abgewandten Kollektoren C₁₁ und C₂₂ der Sensormittel 11, 12 fließenden Ströme.

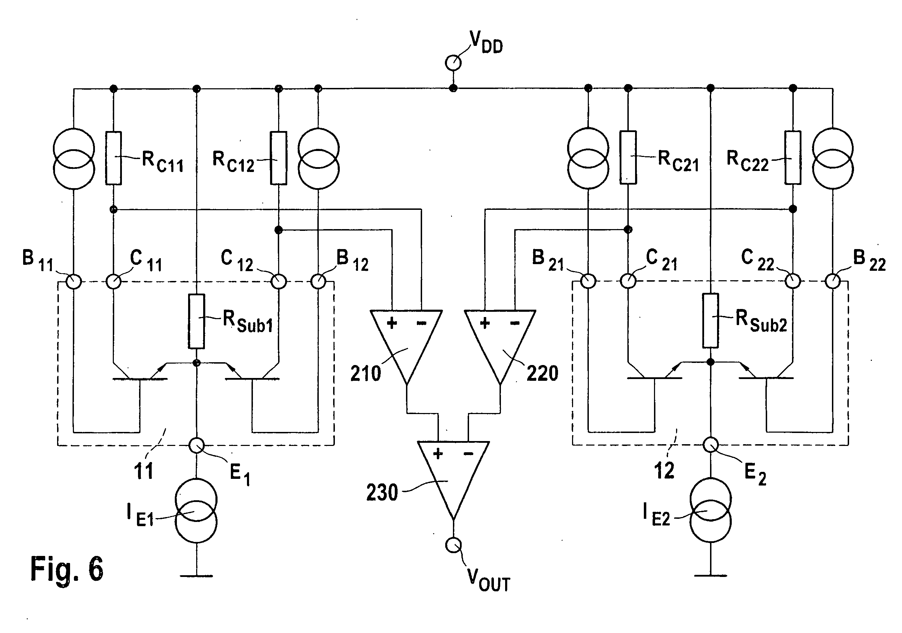

In Figur 6 ist ein Beispiel für eine Auswerteschaltung gemäß dem zweiten Ausführungsbeispiel der erfindungsgemäßen Vorrichtung 10 dargestellt. In Figur 6 ist wiederum das erste Sensormittel 11 mit seinem Emitteranschluss E₁, und seinen beiden Basisanschlüssen B₁₁, B₁₂, sowie seinen beiden Kollektoranschlüssen C₁₁ und C₁₂ dargestellt. Entsprechend ist das zweite Sensormittel 12 mit seinem Emitteranschluss E2 und seinen beiden Basisanschlüssen B₂₁ und B₂₂ beziehungsweise seinen beiden Kollektoranschlüssen C₂₁ und C₂₂ dargestellt. Die Basisanschlüsse der Sensormittel 11, 12 sind in Figur 6 mit der Versorgungsspannung V_{DD} über nicht mittels Bezugszeichen näher bezeichneter Stromquellen verbunden. Die Kollektoranschlüsse C₁₁, C₁₂, C₂₁, C₂₂ sind in Figur 6 über jeweils einen Widerstand mit der Versorgungsspannung verbunden. Hierbei ist der den Kollektor C₁₁ mit der Versorgungsspannung verbindende Widerstand mit dem Bezugszeichen R_{C11} bezeichnet, der den Kollektor C₁₂ mit der Versorgungsspannung verbindende Widerstand mit dem Bezugszeichen R_{C12} bezeichnet und entsprechend der den Kollektor C₂₁ mit der Versorgungsspannung verbindende Widerstand mit dem Bezugszeichen R_{C21} und der den Kollektor C₂₂ mit der Versorgungsspannung verbindende Widerstand mit dem Bezugszeichen R_{C22} bezeichnet. In der Auswerteschaltung des zweiten Ausführungsbeispiels gemäß der Figur 6 werden durch die mittels des Stromes 22 induzierten unterschiedlichen Kollektorströme durch die Widerstände R_{C11}, R_{C12}, R_{C21}, R_{C22} unterschiedlich große Spannungsabfälle erzeugt, die jeweils zwischen dem Kollektor und seinem entsprechenden Widerstand abgreifbar sind. So wird der Spannungsabfall am Widerstand R_{C11} dem invertierenden Eingang eines ersten Differenzverstärkers 210 und der Spannungsabfall am Widerstand R_{C12} dem nicht invertierenden Eingang des ersten Differenzverstärkers 210 zugeführt. Dem invertierenden Eingang eines zweiten Differenzverstärkers 220 wird der Spannungsabfall am Widerstand R_{C21} zugeführt und dem nichtinvertierenden Eingang des zweiten Differenzverstärkers 220 wird der Spannungsabfall am Widerstand R_{C22} zugeführt. Der Ausgang des ersten Differenzverstärkers 210 wird dem nicht invertierenden Eingang eines dritten Differenzverstärkers 230 zugeführt und der Ausgang des zweiten Differenzverstärkers 220 wird dem invertierenden Eingang des dritten Differenzverstärkers 230 zugeführt. Das am dritten Differenzverstärker 230 abgreifbare Ausgangssignal ist dem zu erfassenden Magnetfeld weitgehend proportional. Externe Störfelder bewirken wiederum gleichartige Änderungen der Stromflüsse durch die Kollektoren C₁₂, C₂₂, C₁₁, C₂₁. Die daraus resultierenden Spannungsabfälle an den Widerständen R_{C12}, R_{C22}, R_{C11}, R_{C21} werden durch die Differenzverstärker so zusammengefasst, dass sich keine Wirkung auf das Ausgangssignal ergibt.

Sowohl in Figur 1 als auch in Figur 2 sind an dem Gehäuse 50 noch elektrische Kontaktierungen vorgesehen, die in beiden Figuren mit dem Bezugszeichen 51 versehen sind. Die elektrischen Kontaktierungen 51 dienen zum Anschluss der Auswerteschaltung 30, des Leistungshalbleiterbauelements 20 sowie gegebenenfalls der Sensormittel 11, 12, falls diese eine elektrische Kontaktierung außer mit der Auswerteschaltung 30 benötigen.

Die Auswerteschaltung 30 kann - wie in den Figuren 1 und 2 dargestellt - auf einem einzigen Halbleitersubstrat 40 mit dem Leistungshalbleiterbauelement 20 und den Sensormitteln 11, 12 monolithisch integriert sein oder aber auf einem separaten Halbleitersubstrat abgetrennt von dem Leistungshalbleiterbauelement 20 und den Sensormitteln 11, 12 angeordnet vorgesehen sein. Erfindungsgemäß ist es jedoch insbesondere vorgesehen, dass sowohl das Leistungshalbleiterbauelement 20 als auch die Sensormittel 11, 12 auf einem einzigen Halbleitersubstrat 40 integriert sind.

## Patentansprüche

1. Vorrichtung (10) zur Messung der Stärke eines magnetischen Feldes, wobei erste Sensormittel (11) und zweite Sensormittel (12) vorgesehen sind, wobei weiterhin eine Auswerteschaltung (30) mit dem Sensormittel (11, 12) zusammenwirkt und das erste Sensormittel (11) an einem ersten Ort und das zweite Sensormittel (12) an einem zweiten Ort vorgesehen ist, wobei am ersten Ort und am zweiten Ort das zu messende Feld betragsmäßig im wesentlichen gleich aber im wesentlich antiparallel orientiert ist, **dadurch gekennzeichnet, dass** das erste Sensormittel (11) und das zweite Sensormittel (12) und die Auswerteschaltung (30) auf einem Substrat (40) monolithisch integriert vorgesehen sind und in einem gemeinsamen Gehäuse (50) angeordnet sind und das zu messende Feld in dem Gehäuse (50) generierbar ist, wobei das zu messende Feld von einem Stromfluss (22) generiert wird, der in dem Substrat (40) vorgesehen ist.

2. Vorrichtung (10) nach Anspruch 1, **dadurch gekennzeichnet, dass** der Stromfluss (22) in der Substratebene vorgesehen ist oder das der Stromfluss (22) senkrecht zur Substratebene vorgesehen ist.

3. Vorrichtung (10) nach Anspruch 1 oder 2, **dadurch gekennzeichnet, dass** als Sensormittel (11, 12) Split-Drain-MOSFET-Bauelemente oder laterale Magnetotransistoren vorgesehen sind.

4. Magnetfeldsensor mit einer Vorrichtung (10) nach einem der Ansprüche 1 bis 3.

5. Stromstärkemessgerät mit einer Vorrichtung (10) nach einem der Ansprüche 1 bis 3 oder mit einem Magnetfeldsensor nach Anspruch 4.

## Claims

1. Device (10) for measuring the intensity of a magnetic field, first sensor means (11) and second sensor means (12) being provided, an evaluation circuit (30) also interacting with the sensor means (11, 12), and the first sensor means (11) being provided at a first location and the second sensor means (12) being provided at a second location, the magnitude of the field to be measured being essentially the same at the first location and at the second location but the field being oriented in a substantially anti-parallel manner, **characterized in that** the first sensor means (11) and the second sensor means (12) and the evaluation circuit (30) are monolithically integrated on a substrate (40) and are arranged in a common housing (50), and the field to be measured can be generated in the housing (50), the field to be measured being generated by a flow of current (22) which is provided in the substrate (40).

2. Device (10) according to Claim 1, **characterized in that** the flow of current (22) is provided in the substrate plane, or **in that** the flow of current (22) is provided perpendicular to the substrate plane.

3. Device (10) according to Claim 1 or 2, **characterized in that** split-drain MOSFET components or lateral magnetotransistors are provided as sensor means (11, 12).

4. Magnetic field sensor having a device (10) according to one of Claims 1 to 3.

5. Current intensity measuring instrument having a device (10) according to one of Claims 1 to 3 or having a magnetic field sensor according to Claim 4.

## Revendications

1. Dispositif (10) de mesure de l'intensité d'un champ magnétique, qui présente des premiers moyens de détection (11) et des deuxièmes moyens de détection (12), un circuit d'évaluation (30) coopérant avec le moyen de détection (11, 12), le premier moyen de détection (11) étant prévu en un premier emplacement et le deuxième moyen de détection (12) en un deuxième emplacement, les niveaux du champ à mesurer étant essentiellement identiques sur le premier emplacement et sur le deuxième emplacement mais orientés de façon essentiellement antiparallèle,
**caractérisé en ce que**
le premier moyen de détection (11) et le deuxième moyen de détection (12) ainsi que le circuit d'évaluation (30) sont intégrés monolithiquement sur un substrat (40) et sont disposés dans un boîtier commun (50) et
**en ce que** le champ à mesurer peut être produit dans le boîtier (50), le champ à mesurer étant produit par un écoulement de courant (22) prévu dans le substrat (40).

2. Dispositif (10) selon la revendication 1, **caractérisé en ce que** l'écoulement de courant (22) est prévu dans le plan du substrat ou **en ce que** l'écoulement de courant (22) est prévu perpendiculairement au plan du substrat.

3. Dispositif (10) selon les revendications 1 ou 2, **caractérisé en ce que** des composants MOSFET dits "split-drain" ou des magnétotransistors latéraux sont prévus comme moyens de détection (11, 12).

4. Détecteur de champ magnétique doté d'un dispositif (10) selon l'une des revendications 1 à 3.

5. Appareil de mesure de l'intensité du courant doté d'un dispositif (10) selon l'une des revendications 1 à 3 ou d'un détecteur de champ magnétique selon la revendication 4.
